# EUROPEAN PATENT APPLICATION

(11) **EP 4 443 698 A1**
(43) Date of publication of application: **09.10.2024**
(21) Application number: 24168330.9
(22) Date of filing: 03.04.2024
(51) Int. Cl.: H02J 7/00, H01M 10/42, H05K 5/02, H02B 1/30, H02J 9/06, H02H 3/22, H02H 7/18, H02B 1/21, H02B 1/56

(54) **ENERGY STORAGE MANAGEMENT AND CONTROL SYSTEM**

(30) Priority: 03.04.2023 CN 202320709501 U; 20.03.2024 CN 202420554659 U
(71) Applicant: REPT BATTERO Energy Co., Ltd., 325000 Wenzhou Zhejiang (CN); Shanghai Ruipu Energy Co., Ltd., Shanghai 201206 (CN)
(72) Inventor: CAO, Hui, Longwan District, Wenzhou, Zhejiang (CN); LIU, Si, Pudong New District, Shanghai (CN); Yu, Chen, Pudong New District, Shanghai (CN); ZHANG, Bangming, Pudong New District, Shanghai (CN)
(74) Representative: Potter Clarkson

(57) **Abstract**

The present disclosure provides an energy storage management and control system, comprising an cabinet and electrical components; the internal space of the cabinet is divided into a direct current high-voltage area, a low-voltage communication and control area, and an alternating current power distribution area; and the electrical components comprise a direct current high-voltage electrical component set in the direct current high-voltage area, a low-voltage electrical component and a communication and control electrical component set in the low-voltage communication and control area, and an alternating current power distribution component set in the alternating current power distribution area. The present disclosure divides the internal space of the cabinet into a direct current high-voltage area, a low-voltage communication and control area and an alternating current power distribution area, each of the component areas is arranged relatively and independently, and the direct current high-voltage area and the low-voltage communication and control area are set separately, which reduces the interference between each other and ensures the reliable operation of the energy storage management and control system, and the relatively independent arrangement of the areas is convenient for maintenance.

## Description

### Technical Field

The present disclosure relates to the technical field of measurement and control cabinet, and in particular relates to an energy storage management and control system.

### Background

The main function of the energy storage management and control system is to distribute electrical energy to various load areas by power distribution control, manage batteries, and provide power-off protection in case of short-circuit, overload, and electrical leakage, and so on. The energy storage management and control system can include an energy storage electric control cabinet or an energy storage electric control enclosure. The control of commonly used energy storage electric control cabinet in the prior art is complex and involves a variety of contents, including the battery management system, the measurement and control system, data acquisition units for various sensors, data interaction between the fire alarm host and the measurement and control system, data exchange between the measurement and control system and the battery management system, data exchange between the measurement and control system and the upper-level measurement and control system, data exchange from the battery management system to the upper-level energy management system and the power conversion system, as well as short-circuit overload protection, over-charging and over-discharging protection, over temperature and over voltage protection, impulse voltage protection on the battery side, and so on.

The layout of the current energy storage electric control cabinet is usually to set up the battery management system and the measurement and control system independently as two sets of systems, and these two sets of systems were configured in the busbar cabinet and the measurement and control cabinet, respectively. The battery management system is placed in the busbar cabinet, the measurement and control system is placed in the measurement and control cabinet, and these two independent busbar cabinet and the measurement and control cabinet are placed in a large container. However, usually the total volume of the container is fixed, so that the setup not only increases the cost, but also occupies the valuable space of the container, and also increases the workload of the software in the process of data acquisition and data interaction, and the control strategy is complicated and easy to fail.

In the energy storage system, the energy storage electric control cabinet is usually equipped with only one set of uninterruptible power supply system, once the uninterruptible power supply system fails and cannot output normally, the reliability of power supply of the load equipment under the energy storage system cannot be guaranteed. Moreover, when the energy storage system is applied to the system of voltage mismatch, it is also necessary to configure an additional transformer and a set of power distribution protection system at the alternating current input terminal of the uninterruptible power supply system, which not only increases the construction cost of the system, but also takes up additional space in the container, which is not conducive to the integrated layout of the system.

At present, the interior of the energy storage electric control cabinet is divided into different areas according to function, in which a high-voltage electrical module for connecting the battery cluster is usually provided in the direct current high-voltage area. However, at present, the connection method between the high-voltage electrical module and the battery cluster is fixed, so that the energy storage electric control cabinet can only be applied to a certain connection method. For example, one connection method is that multiple battery clusters are connected in parallel to form one route and then output to the energy storage electric control cabinet, according to this connection method, only one set of high-voltage electrical modules needs to be provided in the energy storage electric control cabinet, and in this type of energy storage electric control cabinet, there is not enough space in the direct current high-voltage area to place more high-voltage electrical modules. If the connection method is changed, for example, if multiple battery clusters are connected in parallel to form two routes and then output to the energy storage electric control cabinet, it is necessary to use an energy storage electric control cabinet with two sets of high-voltage electrical modules. In addition, the connection method of using multiple battery clusters connected in parallel to form one route or two routes of output can lead to problems such as the circulating current among battery clusters and the charging and discharging barrel effect, resulting in batteries being unable to be fully discharged or charged.

### Summary

In view of the above-described drawbacks of the prior art, it is an object of the present disclosure to provide an energy storage management and control system for solving or alleviating the above-described problems of the prior art.

In order to realize the above purposes and other related purposes, in one aspect, the present disclosure provides an energy storage management and control system, comprising a cabinet and electrical components provided in the cabinet; an internal space of the cabinet is divided into a direct current high-voltage area, a low-voltage communication and control area, and an alternating current power distribution area; the electrical components include a direct current high-voltage electrical component, a low-voltage electrical component, a communication and control electrical component, and an alternating current power distribution component, the direct current high-voltage electrical component is provided in the direct current high-voltage area, both the low-voltage electrical component and the communication and control electrical component are provided in the low-voltage communication and control area, and the alternating current power distribution component is provided in the alternating current power distribution area.

In an embodiment of the present disclosure, the direct current high-voltage area is used to connect with multiple battery clusters, the direct current high-voltage area is provided with at least one high-voltage electrical module, the high-voltage electrical module comprising a positive busbar, a negative busbar, and a direct current surge protection unit, the high-voltage electrical module is used to connect with at least one battery cluster and at least one power conversion system, the number of the high-voltage electrical module is the same as the number of the power conversion system, wherein the cabinet is provided with multiple mounting members in the direct current high-voltage area, the multiple mounting members respectively corresponding to the positive busbar, the negative busbar and the direct current surge protection unit, the multiple mounting members are used to enable detachable and fixed connection of the high-voltage electrical module with the cabinet.

In an embodiment of the present disclosure, the communication and control electrical component further comprises an uninterruptible power supply system, the uninterruptible power supply system comprises a main power supply architecture and a backup power supply architecture, the backup power supply architecture responds when the main power supply architecture is unable to work.

In an embodiment of the present disclosure, the uninterruptible power supply system comprises: a first uninterruptible power supply unit, a second uninterruptible power supply unit, a redundant module, and a host computer module; wherein both the first uninterruptible power supply unit and the second uninterruptible power supply unit comprise a switching power supply module, a UPS module, and a lead-acid battery module, respectively, wherein an alternating current input terminal of the switching power supply module is connected to a power grid system, an output terminal of the switching power supply module is connected to an input terminal of the UPS module, an output terminal of the UPS module is connected to an input terminal of the lead-acid battery module, the lead-acid battery module is connected to the redundant module via the UPS module; an output terminal of the redundant module is connected to a load of an energy storage system; an input terminal of the host computer module is connected to the output terminal of the switching power supply module, the output terminal of the UPS module and the output terminal of the redundant module.

The energy storage management and control system of the present disclosure divides the internal space of the cabinet into a direct current high-voltage area, a low-voltage communication and control area, and an alternating current power distribution area, each of the component areas is arranged relatively independent, the direct current high-voltage area and the low-voltage communication and control area are set separately to reduce the interference between each other and to ensure the reliable operation of the energy storage management and control system. And the relatively independent layout of areas facilitates inspection and maintenance. At least one high-voltage electrical module is provided in the direct current high-voltage area, and the high-voltage electrical module can be detachably fixed to the cabinet, so that the energy storage management and control system can be compatible with three types of connection methods between the battery clusters and the power conversion system, and the application scope of the energy storage management and control system is expanded.

The energy storage management and control system of the present disclosure integrates the battery management system and the measurement and control system in the prior art into a set of battery management measurement and control system, and the control module of this system is an integrated industrial control machine, the integrated industrial control machine integrates the external communication unit, i.e., the data interaction between the integrated industrial control machine and the lower-level battery cluster control unit outside the cabinet, the upper-level energy management system, and the power conversion system, and integrated with the I/O module unit, the fire unit, the temperature control unit, and the high-voltage power-on/off control unit, this not only reduces the number of electrical component, lowers the cost, and reduces the valuable space occupied in the cabinet, but also reduces the amount of software engineering, and the control strategy is simple.

The electrical protection and reservation functions in the energy storage management and control system of the present disclosure are complete, including short-circuit overload protection, over-charging and over-discharging protection, over temperature and over voltage protection, impulse voltage protection, emergency stop delay relay protection on the battery side, as well as the switch module, serial bus module and fault alarm dry contact output module for external communication, which are able to meet the requirements of all kinds of different projects, and in addition, the cabinet is equipped with the temperature control unit and the fire unit to ensure the safe operation of electrical equipment.

### Brief Description of the Drawings

The features and performance of the present disclosure are further described by the following embodiments and the accompanying drawings.
FIG. 1 is a schematic diagram of the internal structure of an energy storage management and control system of an embodiment of the present disclosure;
FIG. 2 is a front view of an energy storage management and control system of an embodiment of the present disclosure;
FIG. 3 is a schematic diagram of a structural relationship of an uninterruptible power supply system in an energy storage management and control system of an embodiment of the present disclosure;
FIG. 4 is a schematic diagram of a connection relationship of a switching power supply module in an uninterruptible power supply system of an embodiment of the present disclosure;
FIG. 5 is a schematic diagram of the connection relationship of a UPS module in an uninterruptible power supply system of an embodiment of the present disclosure;
FIG. 6 is a schematic diagram of the connection relationship of a redundant module in an uninterruptible power supply system provided by an embodiment of the present disclosure;
FIG. 7 is a schematic diagram of a high-voltage output management solution for multiple battery clusters including an energy storage management and control system of embodiment 1 of the present disclosure;
FIG. 8 is a schematic diagram of a high-voltage output management solution for multiple battery clusters including an energy storage management and control system of embodiment 2 of the present disclosure;
FIG. 9 is a schematic diagram of a high-voltage output management solution for multiple battery clusters including an energy storage management and control system of embodiment 3 of the present disclosure;
FIG. 10 is a schematic diagram of a three-dimensional structure of an energy storage management and control system of embodiment 1 of the present disclosure;
FIG. 11 is a front view of an energy storage management and control system of embodiment 1 of the present disclosure;
FIG. 12 is a schematic diagram of a circuit structure including a direct current high-voltage area of embodiment 1 of the present disclosure;
FIG. 13 is a back view of an energy storage management and control system of embodiment 1 of the present disclosure;
FIG. 14 is a schematic diagram of a three-dimensional structure of an energy storage management and control system of embodiment 2 of the present disclosure;
FIG. 15 is a front view of an energy storage management and control system of embodiment 2 of the present disclosure;
FIG. 16 is a back view of an energy storage management and control system of embodiment 2 of the present disclosure;
FIG. 17 is a schematic diagram of a three-dimensional structure of an energy storage management and control system of embodiment 3 of the present disclosure;
FIG. 18 is a front view of an energy storage management and control system of embodiment 3 of the present disclosure;
FIG. 19 is a back view of an energy storage management and control system of embodiment 3 of the present disclosure;
FIG. 20 is a cross-sectional stereogram along line AA in FIG. 18;
FIG. 21 is a cross-sectional view along line AA in FIG. 18.

### Preferred Embodiment of the Present Disclosure

It should be noted that the structure, proportion, size, and so on, shown in the drawings attached to this specification are only for the purpose of matching the contents disclosed in the specification for the understanding and reading of those familiar with the technology, and are not intended to limit the conditions under which the present disclosure can be implemented, and therefore do not have any technical significance, and any modification of the structure, change of proportion or adjustment of the size, without prejudice to the effect and purpose of the present disclosure, shall remain within the scope of the technical content disclosed in the present disclosure. Meanwhile, the terms "top", "bottom", "left", "right", "center", "one", and so on, quoted in this specification are only for the purpose of clarity of description and are not intended to limit the scope of the present disclosure, and the changes or adjustments of the relative relationships thereof shall be deemed to be within the scope of the present disclosure without any substantial changes in the technical contents.

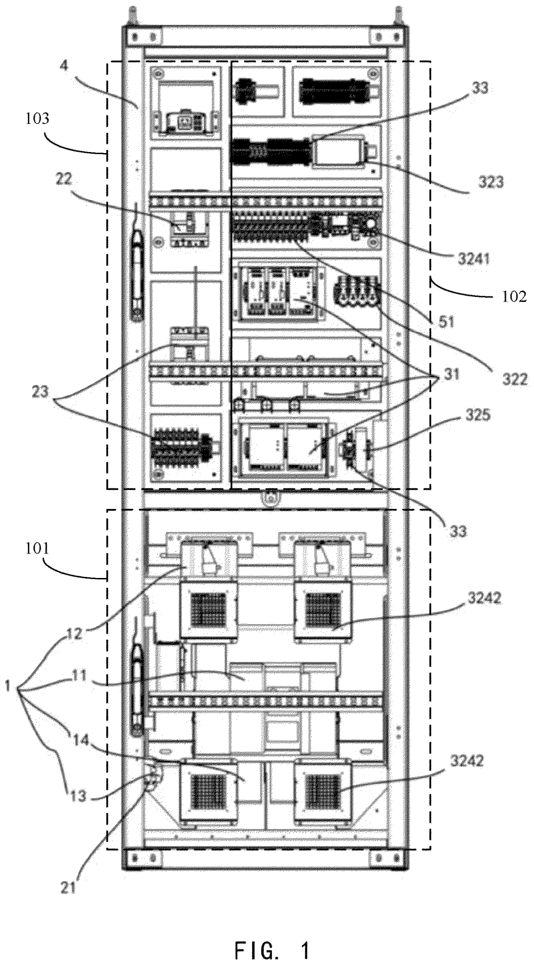

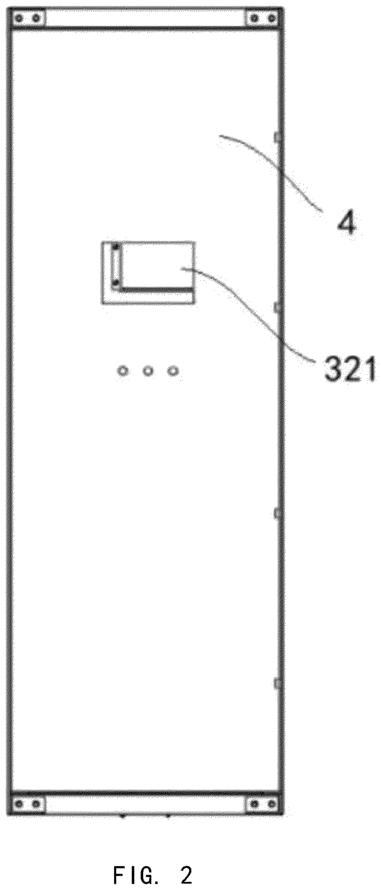

Referring to FIGs. 1 and 2, the present disclosure provides an energy storage management and control system, the energy storage management and control system comprising a cabinet 4 and electrical components, wherein an internal space of the cabinet 4 is divided into a direct current high-voltage area 101, a low-voltage communication and control area 102 and an alternating current power distribution area 103. In this embodiment, the direct current high-voltage area 101 is located in a lower part of the cabinet 4, the low-voltage communication and control area 102 is located in a right upper part of the cabinet 4, and the alternating current power distribution area 103 is located in a left upper part of the cabinet 4, but not limited thereto. In other embodiments, the locations of the direct current high-voltage area 101, the low-voltage communication and control area 102 and the alternating current power distribution area 103 in the cabinet 4 may be set as desired. According to FIGs. 1 and 2, the energy storage management and control system of the present disclosure may be specifically implemented as a partitioned energy storage electric control cabinet or energy storage electric control enclosure in the shape of a rectangular cabinet or enclosure, but it is not intended to limit the specific shape and size of the energy storage management and control system.

The electrical components include the direct current high-voltage electrical component 1, the low-voltage electrical component, the communication and control electrical component, and the alternating current power distribution component, and the direct current high-voltage electrical component 1 is set in the direct current high-voltage area 101, the low-voltage electrical component and the communication and control electrical component are mainly set in the low-voltage communication and control area 102, and the alternating current power distribution component is mainly set in the alternating current power distribution area 103, and each electrical component is set separately to reduce interference between each other and to ensure reliable operation of the energy storage management and control system, and the relatively independent arrangement of the areas also facilitates maintenance. Among them, the direct current high-voltage electrical component 1 includes the high-voltage direct current load switch 11 and the high-voltage direct current incoming and outgoing busbar 14, the high-voltage direct current load switch 11 and the high-voltage direct current incoming and outgoing busbar 14 are fixed on the access panel, and the access panel can be detachably connected to the inner wall of the cabinet 4, so as to facilitate the maintenance of the high-voltage direct current load switch 11 and the high-voltage direct current incoming and outgoing busbar 14. The high-voltage direct current incoming and outgoing busbar 14 may be specifically a copper busbar. The communication and control electrical component includes a battery management measurement and control system, and the battery management measurement and control system performs data interaction with the lower-level battery cluster control unit, the upper-level energy management system, and the power conversion system, respectively. Unlike the current solution of independently setting the battery management system and the measurement and control system into two sets of systems, the present disclosure integrates the battery management system and the measurement and control system into one set of battery management measurement and control system, and the set of battery management measurement and control system integrates an external communication unit, which not only reduces the number of electrical component, lowers the cost, and reduces the amount of space occupied in the cabinet 4, but also reduces the amount of software engineering to achieve centralized control, and the control strategy is simple.

Specifically, the high-voltage direct current load switch 11 is set at the busbar output terminal of the direct current high-voltage area 101, which can control the turning on and turning off the switch remotely or manually, so that in the event of various types of emergency failures, the battery management measurement and control system can timely control the high-voltage direct current load switch 11 to be turned off to disconnect the electrical connection between the battery side and the power conversion system; and the battery management measurement and control system can monitor the on/off status of the high-voltage direct current load switch 11 in real time.

Specifically, the low-voltage electrical components are commonly used components in the low-voltage power distribution system 33 in the related field and are not unduly limited herein.

As an example, referring to FIGs. 1 and 2, the battery management measurement and control system includes an integrated industrial control machine 321, a high-voltage power-on/off control unit 322, a fault alarm dry contact output module, a switch module 325 and/or a serial bus module; the high-voltage power-on/off control unit 322 is connected to an output terminal of the integrated industrial control machine 321, and the integrated industrial control machine 321 issues commands by the high-voltage power-on/off control unit 322, the high-voltage power-on/off control unit 322 controls the on/off of the high-voltage direct current load switch 11; the integrated industrial control machine 321 performs data interaction with the upper-level energy management system via the switch module 325; the integrated industrial control machine 321 performs data interaction with the power conversion system via the switch module 325 or the serial bus module; the integrated industrial control machine 321 performs data interaction with the fault alarm dry contact output module via the switch module 325 or the serial bus module and informs the power conversion system via hardwired alarm.

Specifically, the integrated industrial control machine 321 is the master control module of the battery management measurement and control system and integrates the external communication unit. The integrated industrial control machine 321 performs data interaction with the upper-level energy management system by Ethernet or optical communication of the switch module 325, reports fault information, receives commands from the upper-level energy management system and performs protection actions, the protection actions specifically include: the high-voltage power-on/off control unit 322 controls the high-voltage direct current load switch 11 to cut off the high-voltage electrical connection; the integrated industrial control machine 321 performs data interaction with the power conversion system via the switch module 325 or the serial bus module, reporting fault information, and optionally sending hardwired alarm to the power conversion system, the power conversion system reduces power in time and waits for shutdown, then the integrated industrial control machine 321 controls the high-voltage power-on/off control unit 322 to disconnect the high-voltage direct current load switch 11 to cut off the high-voltage electrical connection, and gives the direct current to the lower-level battery cluster control unit to disconnect the battery cluster level electrical connection.

As an example, the battery management measurement and control system further includes a temperature control unit, the temperature control unit including a temperature controller 3241 and a plurality of cooling fans 3242; the acquisition terminal of the temperature controller 3241 collects the ambient temperature in the cabinet 4, the data transmission terminal of the temperature controller 3241 is connected to the integrated industrial control machine 321 via the serial bus module, and the temperature controller 3241 transmits the collected ambient temperature to the integrated industrial control machine 321. It is to be noted that some of the cooling fans 3242 may be located anywhere in the cabinet 4 and are not limited to the low-voltage communication and control area 102.

Specifically, when the ambient temperature collected by the temperature controller 3241 is higher than the preset temperature threshold, the temperature controller 3241 controls the cooling fan 3242 to turn on and work, and when the ambient temperature collected by the temperature controller 3241 is lower than the preset temperature threshold, the temperature controller 3241 controls the cooling fan 3242 to stop working. The ambient temperature within the cabinet 4 collected by the temperature controller 3241 is output to the integrated industrial control machine 321 via the serial bus module, and when the temperature data collected by the temperature controller 3241 is greater than the preset temperature alarm value (the temperature alarm value is higher than the temperature threshold value), the integrated industrial control machine 321 informs the upper-level energy management system via Ethernet or optical communication via the switch module 325, and then controls the fault alarm dry contact output module to inform the power conversion system to reduce power and shut down by hardwired alarm, and then controls the high-voltage direct current load switch 11 to cut off the high-voltage electrical connection via the high-voltage power-on/off control unit 322, and gives instruction to the lower-level battery cluster to disconnect the cluster level electrical connection.

As an example, a plurality of upper heat dissipation ports (not shown in the figure) are provided throughout the top wall of the cabinet 4, a plurality of lower heat dissipation ports (not shown in the figure) are provided throughout the lower side wall of the cabinet 4, and the cooling fans 3242 are provided in both the upper heat dissipation ports and the lower heat dissipation ports.

Specifically, the cooling fans 3242 are distributed in the upper heat dissipation ports and the lower heat dissipation ports correspondingly, and the purpose of such a setting is to realize convection of the gases in the cabinet 4 by means of the cooling fans 3242 in the upper heat dissipation ports and the lower heat dissipation ports, so as to rapidly cool down the temperature.

As an example, the battery management measurement and control system further comprises a fire unit, the fire unit comprises a smoke sensor, the smoke sensor is connected to a fire system host outside the cabinet, and the fire system host outside the cabinet is connected to the integrated industrial control machine 321.

Specifically, the smoke sensor is used to monitor the smoke concentration within the cabinet 4, and when the smoke sensor monitors that the smoke concentration within the cabinet 4 exceeds a preset smoke concentration threshold, then the smoke sensor sends a smoke alarm signal to the fire system host outside the cabinet, and after acquiring the smoke alarm signal from the fire system host, the integrated industrial control machine 321 controls the high-voltage power-on/off control unit 322 to power-off. When fire occurs in the cabinet 4, the fire system host controls the alarm response, and after receiving the alarm information from the fire system host, the integrated industrial control machine 321 informs the upper-level energy management system by the Ethernet or optical communication supporting the switch module 325, and then controls the fault alarm dry contact output module to inform the power conversion system to reduce power and shut down by hardwired alarm, and then controls the high-voltage direct current load switch 11 to cut off the high-voltage electrical connection by the high-voltage power-on/off control unit 322, and gives instructions to the lower-level battery cluster to disconnect the cluster level electrical connection.

As an example, the battery management measurement and control system further includes an I/O module unit 323, the I/O module unit 323 is used to collect information, and the I/O module unit 323 transmits the collected information to the integrated industrial control machine 321 via the serial bus module.

Specifically, the I/O module unit 323 collects various types of information and transmits the collected information to the integrated industrial control machine 321, and when the state collected by the I/O module unit 323 is abnormal, the integrated industrial control machine 321 informs the upper-level energy management system by Ethernet or optical communication of the switch module 325, and informs the power conversion system of the hardwired alarm by the fault alarm dry contact output module so as to enable the power conversion system to reduce power and shut down in time; and then disconnect the high-voltage direct current load switch 11 by controlling the high-voltage power-on/off control unit 322 to cut off the high-voltage electrical connection, and gives instruction to the lower-level battery cluster control unit to disconnect the cluster level electrical connection.

As an example, the communication and control electrical component further comprises an uninterruptible power supply system 31, the uninterruptible power supply system 31 comprising a main power supply architecture and a backup power supply architecture, the backup power supply architecture responds when the main power supply architecture is unable to work.

Specifically, the backup power supply architecture responds to the inoperativeness of the main power supply architecture to ensure that the power supply of the uninterruptible power supply system 31 is normal, and each module of the uninterruptible power supply system 31 is equipped with the status feedback function, and the I/O module unit 323 can collect the status information of each module of the uninterruptible power supply system 31 and transmit the collected status information to the integrated industrial control machine 321 via the serial bus module, and the integrated industrial control machine 321 can monitor the status information of each module of the uninterruptible power supply system 31 in real time, when a module of the uninterruptible power supply system 31 is monitored to be abnormal, the integrated industrial control machine 321 may control the high-voltage power-on/off control unit 322 to disconnect the high-voltage direct current load switch 11 in time.

As an example, the direct current high-voltage electrical component 1 further comprises a protection unit, the protection unit comprising a high-voltage direct current surge protection device 13 and two high-voltage direct current fuses 12, the high-voltage direct current surge protection device 13 is disposed at a busbar output terminal of the direct current high-voltage area 101, and the two high-voltage direct current fuses 12 are disposed at a positive input terminal and a negative input terminal of a direct current bus of the direct current high-voltage area 101, respectively.

Specifically, the high-voltage direct current surge protection device 13 is set at the busbar output terminal of the direct current high-voltage area 101 to avoid the damage of the direct current side due to overvoltage impact. When overvoltage is generated on the direct current bus due to an external lightning strike or due to the turning on and turning off of the high-voltage direct current load switch 11, when the overvoltage value exceeds the value of the voltage protection level of the high-voltage direct current surge protection device 13, the high-voltage direct current surge protection device 13 is triggered to promptly discharge overvoltage to the ground; the high-voltage direct current surge protection device 13 has status feedback, and the I/O module unit 323 can collect the status information of the high-voltage direct current surge protection device 13 and transmit the collected information to the integrated industrial control machine 321 via the serial bus module, so that when an abnormality is detected, the integrated industrial control machine 321 can control the high-voltage power-on/off control unit 322 to disconnect the high-voltage direct current load switch 11 in time.

Specifically, the two high-voltage direct current fuses 12 are respectively set at a positive input terminal and a negative input terminal of the direct current bus of the direct current high-voltage area 101 to increase the reliability of the short-circuit protection function. The high-voltage direct current fuse 12 is equipped with state feedback function, and the I/O module unit 323 can collect the status information of the high-voltage direct current fuse 12 and transmit the collected information to the integrated industrial control machine 321 via the serial bus module, when the state of the high-voltage direct current fuse 12 is found to be abnormal, the integrated industrial control machine 321 informs the upper-level energy management system by Ethernet or optical communication supporting the switch module 325, and then controls the fault alarm dry contact output module to inform the power conversion system to reduce power and shut down by hardwired alarm, and then controls the high-voltage direct current load switch 11 to cut off the high-voltage electrical connection by the high-voltage power-on/off control unit 322, and gives instructions to the lower-level battery cluster to disconnect the cluster level electrical connection.

As an example, the electrical component includes a manual hard emergency stop unit, the manual hard emergency stop unit includes a delay relay 51, the delay relay 51 is set in the low-voltage communication and control area 102 (set in the low-voltage communication and control area 102 to avoid safety risks caused by accidental touching of the high-voltage component by the operator when operating manually) and is communicatively connected to the high-voltage direct current load switch 11. When the manual hard emergency stop unit is manually controlled, the delay relay 51 controls the disconnection of the high-voltage direct current load switch 11.

Specifically, the delay relay 51 can delay disconnection of the battery cluster level relay, so that when the manual hard emergency stop unit is manually controlled to make an emergency stop, the high-voltage direct current load switch 11 is disconnected, and disconnection of the drive power supply circuit fitted to the battery cluster level relay is delayed by the response of the delay relay 51, so that the battery cluster level relay is delayed, and the battery cluster level relay is prevented from being damaged due to on-load disconnection.

Preferably, the temperature controller 3241 is set close to the delay relay 51 for monitoring the ambient temperature at the delay relay 51. Due to the small amount of heat generated by the delay relay 51, it is representative of the ambient temperature inside the cabinet 4.

As an example, the alternating current power distribution component includes an alternating current surge protection device 21, the alternating current surge protection device 21 is provided on an input side of the direct current high-voltage area 101.

Specifically, the alternating current surge protection device 21 is set on an input side of the direct current high-voltage area 101 to avoid damage to the alternating current system due to overvoltage impact and to ensure that the overvoltage category of the alternating current system is class II. In addition, overvoltage is generated in the alternating current system due to external lightning strikes or the turning on and turning off of the high-voltage direct current load switch 11, when the value of overvoltage exceeds the value of voltage protection level of the alternating current surge protection device 21, the alternating current surge protection device 21 triggers an action to discharge the overvoltage to the ground in time by a grounding copper bar, the grounding copper bar is set at the bottom of the cabinet 4; the alternating current surge protection device 21 is equipped with a status feedback, and the I/O module unit 323 can collect the status information of the alternating current surge protection device 21 and transmit the collected information to the integrated industrial control machine 321 via the serial bus module, and the battery management measurement and control system can monitor the status of the alternating current surge protection device 21 in real time, which can promptly detect the abnormality and control the high-voltage power-on/off control unit 322 to disconnect the high-voltage direct current load switch 11 to power off the high-voltage.

In addition, the alternating current power distribution component further includes a main input circuit breaker 22, a plurality of feeder circuit breakers 23. With respect to the structure and function of the main input circuit breaker 22 and the feeder circuit breaker 23 are all known in the field, and are not unduly limited herein.

The energy storage management and control system of the present disclosure integrates the battery management system and the measurement and control system in the prior art into a set of battery management measurement and control system, and the control module of this system is the integrated industrial control machine 321, the integrated industrial control machine 321 integrates the external communication unit, i.e., the data interaction between the integrated industrial control machine 321 and the lower-level battery cluster control unit outside the cabinet 4, the upper-level energy management system, and the power conversion system, and integrated with the I/O module unit, the fire unit, the temperature control unit, and the high-voltage power-on/off control unit, this not only reduces the number of electrical component, lowers the cost, and reduces the valuable space occupied in the cabinet, but also reduces the amount of software engineering, and the control strategy is simple. At the same time, the system divides the internal space of the cabinet into a direct current high-voltage area 101, a low-voltage communication and control area 102, and an alternating current power distribution area 103, each of the component areas is arranged relatively and independently, the direct current high-voltage area 101 and the low-voltage communication and control area 102 are set up separately to reduce the interference between each other and to ensure that the energy storage management and control system can work reliably, and the relatively independent layout of areas facilitates inspection and maintenance. The electrical protection and reservation functions in the energy storage management and control system of the present disclosure are complete, including short-circuit overload protection, over-charging and over-discharging protection, over temperature and over voltage protection, impulse voltage protection, emergency stop delay relay protection on the battery side, as well as the switch module, serial bus module and fault alarm dry contact output module for external communication, which are able to meet the requirements of all kinds of different projects, and in addition, the cabinet is equipped with the temperature control unit and the fire unit to ensure the safe operation of electrical equipment.

The following expansion describes the uninterruptible power supply system 31 in the energy storage management and control system of the present disclosure.

It should be noted that the full English name of UPS is Uninterruptible Power Supply, it is a system equipment that connects the battery to the host and converts direct current power into mains supply by the module circuit such as the host inverter, mainly used to provide stable and uninterrupted power supply to a single computer, computer network system or other power electronic equipment such as the solenoid valve, the pressure transmitter, and so on.

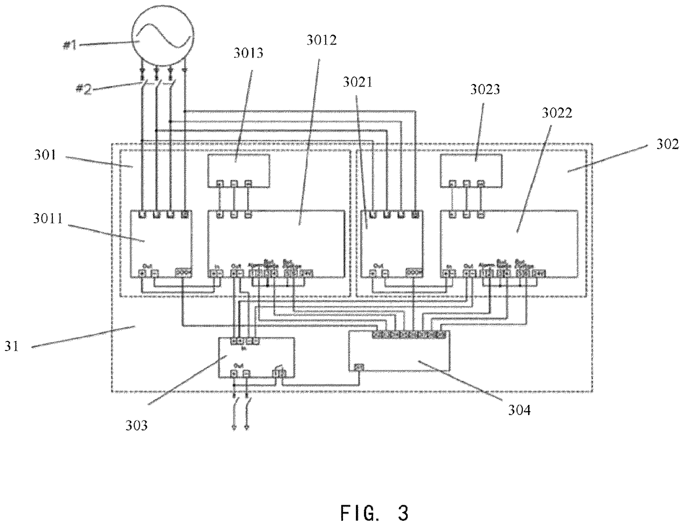

FIG. 3 is a schematic diagram of a structural relationship of an uninterruptible power supply system in an energy storage management and control system of an embodiment of the present disclosure. Referring to FIG. 3, the uninterruptible power supply system 31 comprises a first uninterruptible power supply unit 301, a second uninterruptible power supply unit 302, a redundant module 303, and a host computer module 304, wherein each uninterruptible power supply unit comprises a switching power supply module, a UPS module, and a lead-acid battery module, i.e., both of the first uninterruptible power supply unit 301 and the second uninterruptible power supply unit 302 respectively comprise the switching power supply module, the UPS module, and the lead-acid battery module, and, the alternating current input terminal of the switching power supply module is connected to the power grid system #1 via the circuit breaker #2; the output terminal of the switching power supply is connected to the input terminal of the UPS module; the output terminal of the UPS module is connected to the input terminal of the lead-acid battery module; the lead-acid battery module is connected to the redundant module via the UPS module; the output terminal of the redundant module is connected to the load of the energy storage system; the input terminal of the host computer module is connected to the output terminal of the switching power supply module, the output terminal of the UPS module, and the output terminal of the redundant module.

It is to be noted that the first uninterruptible power supply unit 301 and the second uninterruptible power supply unit 302 may respectively correspond to the main power supply architecture and the backup power supply architecture as described previously.

In the present disclosure embodiment, the first uninterruptible power supply unit 301 and the second uninterruptible power supply unit 302 have the same module structure. As shown in FIG. 3, the first uninterruptible power supply unit 301 comprises the switching power supply module 3011, the UPS module 3012, and the lead-acid battery module 3013; the second uninterruptible power supply unit 302 comprises the switching power supply module 3021, the UPS module 3022, and the lead-acid battery module 3023. Due to the first uninterruptible power supply unit 301 and the second uninterruptible power supply unit 302 have the same module and same connection relationship, for simplicity and convenience of description, the embodiment of the present disclosure describes the connection relationship of each module within the first uninterruptible power supply unit 301 in specific descriptions, and these specific descriptions are applicable to illustrate the connection relationship of each module within the second uninterruptible power supply unit 302 and the interaction relationship.

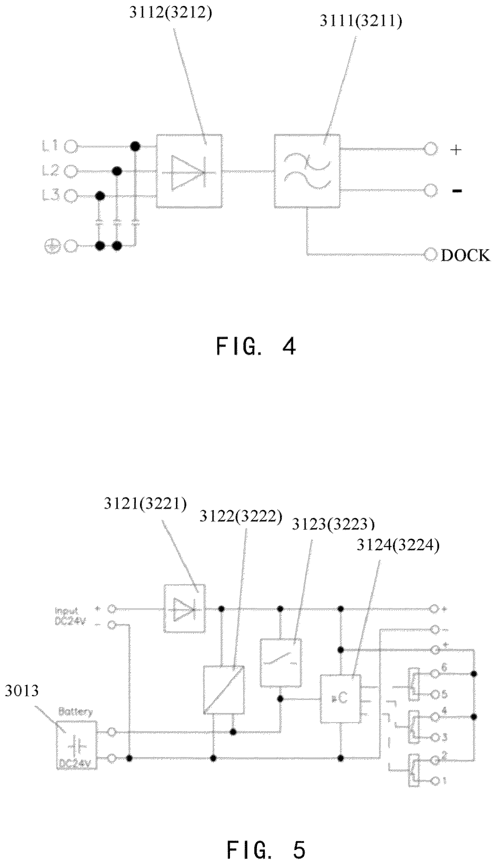

FIG. 4 is a schematic diagram of a connection relationship of a switching power supply module in an uninterruptible power supply system of an embodiment of the present disclosure. Preferably, as shown in conjunction with FIGs. 3 and 4, in the first uninterruptible power supply unit 301, the switching power supply module 3011 comprises the rectifier module 3112 and the filter module 3111, the alternating current input terminal of the rectifier module 3112 is connected to the power grid system #1 via the circuit breaker #2, and the output terminal of the rectifier module 3112 is connected to the input terminal of the filter module 3111, and the rectifier module 3112 is used to rectify the alternating current power sent by the power grid system # 1 into the low-voltage direct current power; the output terminal of the filter module 3111 is connected to the input terminal of the UPS module 3012, and the low-voltage direct current power is filtered by the filter module 3111 and then output to the UPS module 3012. Similarly, in the second uninterruptible power supply unit 302, the switching power supply module 3021 contains the rectifier module 3212 and the filter module 3211. Exemplarily, after rectification and filtering, the switching power supply module 3011 converts the 400V alternating current power sent by the power grid system into 24V direct current power to output a 24V voltage signal. The switching power supply module 3011 can convert the alternating current power sent by the power grid system into voltage signals of different voltage values and then output them to match systems with different voltage input requirements. It is not necessary to configure a transformer and a power distribution protection system at the alternating current input terminal of the uninterruptible power supply system 31, reducing the cost of constructing the system and the area occupied by the system. In other possible implementations, the voltage value of the alternating current power sent by the power grid system and the voltage value of the low-voltage direct current power converted by the switching power supply module 3011 may be other values. It is to be noted that the embodiments of the present disclosure take the combination and connection relationship between the individual modules as the focus of the solution, and the specific component of each module is set up in terms of the actual application, and are not limited herein.

In an embodiment, the alternating current input terminal of the switching power module 3011 is connected to the power grid system via the circuit breaker #2, specifically: the alternating current input terminal of the rectifier module is connected to one terminal of the circuit breaker #2; the other terminal of the circuit breaker #2 is connected to the power grid system. Before connecting the switching power supply module 3011 to the power grid system, it is also necessary to provide a circuit breaker in the connection of the switching power supply module 3011 to the power grid system in order to ensure the safety of power supply from the power grid system distribution to the uninterruptible power supply system 31. Preferably, as shown in conjunction with FIGs. 3 and 4, the alternating current input terminal of the rectifier module 3112 is connected to the lower terminal of the circuit breaker #2, and the upper terminal of the circuit breaker #2 is connected to the power grid system #1. Correspondingly, the alternating current input terminal of the rectifier module 3212 in the second uninterruptible power supply unit 302 is also connected to the lower terminal of the circuit breaker #2.

In an embodiment, the UPS module includes a decoupling module, a charging module, a first switching element, and a dry contact module, specifically: the input terminal of the decoupling module is connected to the output terminal of the switching power supply module; the output terminal of the decoupling module is connected to the input terminal of the charging module, the first switching element, the input terminal of the dry contact module, the input terminal of the redundant module; and the input terminal of the lead-acid battery module is connected to the output terminal of the charging module, the first switching element, and the output terminal of the dry contact module. FIG. 5 is a schematic diagram of the connection relationship of the UPS module of an embodiment of the present disclosure. Preferably, as shown in conjunction with FIGs. 3 to 5, in the first uninterruptible power supply unit 301, the UPS module 3012 comprises the decoupling module 3121, the charging module 3122, the first switching element 3123, and the dry contact module 3124. The decoupling module 3121 is connected to the output terminal of the filter module 3111, and the decoupling module 3121 causes the low-voltage direct current power output from the filter module 3111 to realize a unidirectional output, and controls the transmission of the low-voltage direct current power to the charging module 3122. When the output of the switching power supply module 3011 is normal, the charging module 3122 charges the lead-acid battery module 3013 until the lead-acid battery module 3013 is fully charged. When the output of the switching power supply module 3011 is abnormal, the power supply of the lead-acid battery module 3013 to the load is realized by switching of the first switching element 3123. In the embodiment of the present disclosure, power is supplied to the load by the switching power supply module 3011 through the UPS module 3012 and the redundant module 303 in turn, and the first switching element 3123 is provided in the UPS module 3012 to charge the lead-acid battery module 3013 when the switching power supply module 3011 passes through the UPS module 3012. If the switching power supply module 3011 operates abnormally, the lead-acid battery module 3013 can be connected to the power supply circuit by the first switching element 3123, and the lead-acid battery module 3013 passes through the UPS module 3012 and the redundant module 303 in turn, replacing the abnormally operating switching power supply module 3011 to supply power to the load, and further improving the reliability of the power supply of the uninterruptible power supply. The dry contact module 3124 is used to characterize the operating state of the entire UPS module 3012. As shown in FIG. 5, the first output pin 1 and the second output pin 2 of the dry contact module 3124 are a pair of dry contacts. When fault occurs in the UPS module 3012, the pair of dry contacts is disconnected, indicating that there is a fault in the UPS module 3012 at this moment. Accordingly, in the second uninterruptible power supply unit 302, the UPS module 3022 comprises the decoupling module 3221, the charging module 3222, the first switching element 3223, and the dry contact module 3224. The specific workflow of the UPS module 3022 as well as the connection relationship can be referred to the UPS module 3021, which will not be discussed herein.

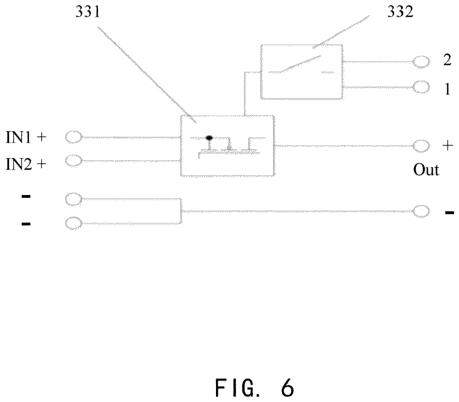

In an embodiment, the redundant module comprises a MOS tube module and a normally closed dry contact, specifically: the input terminal of the MOS tube module is connected to the output terminal of the UPS module; the output terminal of the MOS tube module is connected to the load of the energy storage system; and the MOS tube module is connected to the first digital interface of the host computer module via the normally closed dry contact. FIG. 6 is a schematic diagram of a connection relationship of a redundant module provided by an embodiment of the present disclosure. Preferably, with reference to FIG. 6, the redundant module 303 comprises the MOS tube module 331 and the normally closed dry contact 332. The first input terminal IN1 of the MOS tube module 331 is connected to the output terminal of the UPS module 3012 in the first uninterruptible power supply unit 301, that is the output terminal of the decoupling module 3121, and the second input terminal IN2 is connected to the output terminal of the UPS module 3022 in the second uninterruptible power supply unit 302, that is the output terminal of the decoupling module 3221. The output terminal of the MOS tube module 331 is connected to the load of the energy storage system. As shown in FIG. 6, the pin 1 and the pin 2 in the redundant module 303 are a pair of normally closed dry contacts, and when the output of the MOS tube module 331 is normal, the dry contacts of pin 1 and pin 2 are in a closed state, and the pin 2 will output a 24V voltage signal. Conversely, if the pin 2 has no voltage signal output, connect the pin 2 to the first digital interface DI1 of the host computer module 304. When there is no 24V digital signal input to the interface DI1 of the host computer module 304, it indicates that the output state of the redundant module 303 is abnormal, and the energy storage system can be controlled by the host computer module 304 to save the data and release maintenance warning information to the monitoring background. It should be noted that the input terminals of the host computer module 304 correspond to the digital interfaces DI1 to DI9.

In an embodiment, the input terminal of the host computer module is connected to the output terminal of the switching power supply module, specifically: a second digital interface of the host computer module is connected to a DOCK pin of the filter module. Preferably, referring to FIG. 3, the second digital interface DI2 of the host computer module 304 is connected to the output terminal of the filter module 3111 in the switching power supply module 3011. When the output of the switching power supply module 3011 is normal, the filter module 3111 will output a 24V digital signal at the DOCK pin, and when the host computer module 304 receives a 24V digital signal at the pin DI1, it can determine that the output of the switching power supply module 3011 is normal. If the host computer module 304 cannot receive a 24V digital signal at the pin DI2, the output of the switching power supply module 3011 is determined to be abnormal, and at this time, the energy storage system can be controlled to save the data and issue maintenance warning information to the monitoring background. The sixth digital interface DI6 of the host computer module 304 is connected to the DOCK pin of the filter module 3211 in the switching power supply module 3021.

In an embodiment, the input terminal of the host computer module is connected to the output terminal of the UPS module, specifically: the second output pin of the dry contact module is connected to the third digital interface of the host computer module; wherein the first output pin and the second output pin of the dry contact module are a pair of dry contacts; the fourth output pin of the dry contact module is connected to the fourth digital interface of the host computer module; wherein the third output pin and the fourth output pin of the dry contact module are a pair of dry contacts; the sixth output pin of the dry contact module is connected to the fifth digital interface of the host computer module; wherein the fifth output pin and the sixth output pin of the dry contact module are a pair of dry contacts. Preferably, as shown in conjunction with FIGs. 3 and 5, the second output pin 2 of the dry contact module 3124 is connected to the third digital interface DI3 of the host computer module 304, and when the output of the UPS module 3012 is normal, the first output pin 1 and the second output pin 2 of the dry contact module 3124 are in a closed state, and at this time, the third digital interface DI3 of the host computer module 304 receives a 24V digital signal input, determine the working status of the UPS module 3012 is normal. If the output of the UPS module 3012 is abnormal, then the dry contact module 3124 makes the first output pin 1 and the second output pin 2 disconnected, and at this time, the third digital interface DI3 of the host computer module 304 has no 24V digital signal input, and the host computer module 304 determines the fault alarm of the UPS module 3012, and controls the energy storage system to save the data, reduces power and power off the high-voltage, and releases the maintenance early warning information to the monitoring background.

As shown in FIG. 5, the dry contact module 3124 comprises six output pins. The fourth output pin 4 of the dry contact module 3124 is connected to the fourth digital interface DI4 of the host computer module 304, the third output pin 3 and the fourth output pin 4 are a pair of dry contacts. When there is no 24V digital signal input to the fourth digital interface DI4 of the host computer module 304, then it is determined that the UPS module 3012 is in the battery discharging mode at the moment. The sixth output pin 6 of the dry contact module 3124 is connected to the fifth digital interface DI5 of the host computer module 304, and when there is no 24V digital signal input to the fifth digital interface DI5 of the host computer module 304, it is determined that the UPS module 3012 is in the battery charging mode at the moment. As a supplementary solution of the present disclosure, in the second uninterruptible power supply unit 302, the second output pin 2 of the dry contact module 3224 in the UPS module 3022 is connected to the seventh digital interface DI7 of the host computer module 304, the fourth output pin 4 is connected to the eighth digital interface DI8 of the host computer module 304, and the sixth output pin 6 is connected to the ninth digital interface DI9 of the host computer module 304. The specific working process between the UPS module 3022 and the host computer module 304 can be found in the UPS module 3012 and will not be repeated here.

According to the uninterruptible power supply system 31 provided in the above embodiment, two sets of uninterruptible power supply units are provided under the uninterruptible power supply system 31, so as to safeguard the normal output of the uninterruptible power supply system 31 when one set of the uninterruptible power supply units fails, and to improve the reliability of power supply to the energy storage system. The uninterruptible power supply system 31 is also provided with the host computer module 304, connecting the input terminal of the host computer module 304 with the output terminals of each module in the uninterruptible power supply unit and the redundant module, and realizing the determination of the output terminal of each module in the uninterruptible power supply system 31 by the connection relationship between the host computer module 304 and each module, so as to further improve the reliability of the power supply to the energy storage system.

The energy storage management and control system of the present disclosure can be used to manage multiple battery clusters, and is particularly suitable for application scenario of containerized energy storage system. Three embodiments of the energy storage management and control system are described below, respectively.

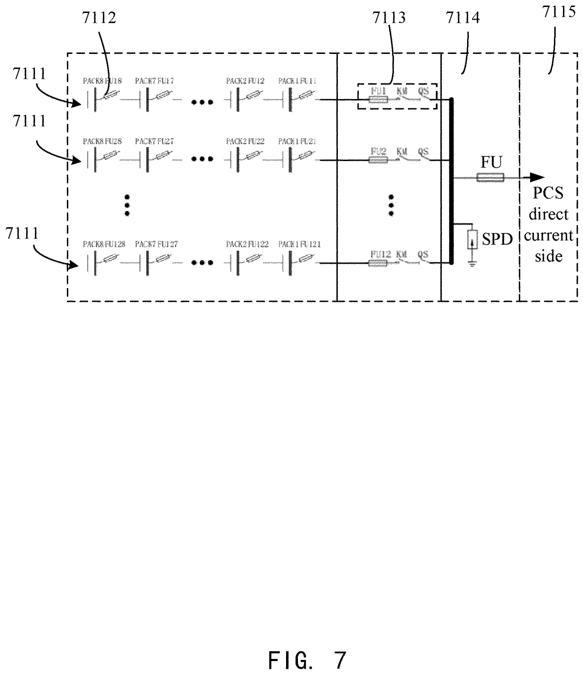

FIG. 7 is a schematic diagram of a high-voltage output management solution for multiple battery clusters including an energy storage management and control system of embodiment 1 of the present disclosure. As shown in FIG. 7, therein is illustrated a plurality of battery clusters 7111, each battery cluster 7111 includes a plurality of battery packs 7112 connected in series. The plurality of battery clusters 7111 belong to a battery stack. Each battery cluster 7111 is connected to a corresponding high-voltage box 7113, and after passing through the high-voltage box 7113, the plurality of battery clusters 7111 are connected in parallel to form one output to the energy storage management and control system 7114, and after passing through the energy storage management and control system 7114 are output to a direct current side of the power conversion system 7115 (PCS). The energy storage management and control system 7114 includes a set of high-voltage electrical modules including a fuse (FU) and a surge protection device (SPD). FIG. 7 shows multiple battery clusters 7111 connected in parallel as one high-voltage output, and therefore, this solution is referred to as the "multiple clusters connected in parallel to form one high-voltage output solution".

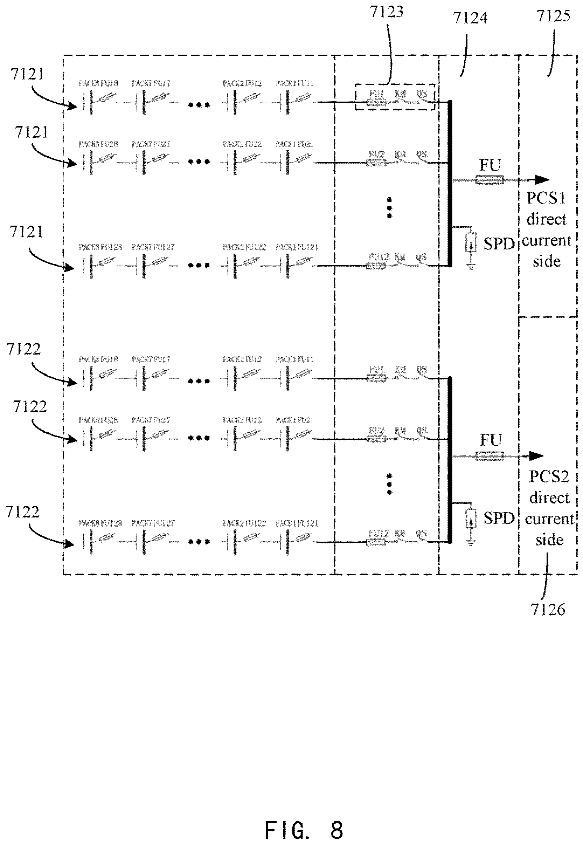

FIG. 8 is a schematic diagram of a high-voltage output management solution for multiple battery clusters including an energy storage management and control system of embodiment 2 of the present disclosure. As shown in FIG. 8, wherein the plurality of battery clusters 7121 belong to a battery stack, and the plurality of battery clusters 7122 belong to another battery stack. The plurality of battery clusters 7121 are connected in parallel to form one output after passing through the high-voltage box 7123, and is output to the direct current side of other power conversion system 7125 after passing through one group of high-voltage electrical modules in the energy storage management and control system 7124. The plurality of battery clusters 7122 are connected in parallel to form one output after passing through the high-voltage box 7123, and is output to the direct current side of other power conversion system 7126 after passing through another group of high-voltage electrical modules in the energy storage management and control system 7124. As a whole, the multiple battery clusters 7121, 7122 are connected in parallel to form two high-voltage outputs, and therefore, this solution is referred to as the "multiple clusters connected in parallel to form two high-voltage outputs solution".

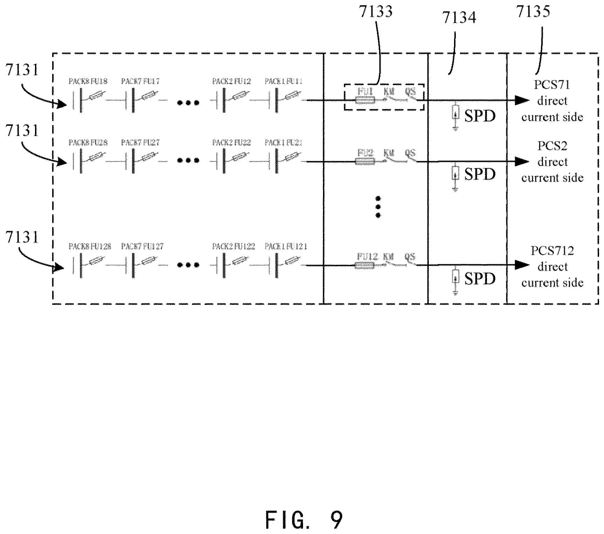

In the two solutions shown in FIGs. 7 and 8, the energy storage management and control system 7114 and 7124 have the characteristics of simple architecture and low system cost, but the two solutions have problems such as inter-cluster circulating current and charging and discharging barrel effect. Therefore, the present disclosure proposes a "one-cluster-one-management high-voltage output solution". FIG. 9 is a schematic diagram of a high-voltage output management solution for multiple battery clusters including an energy storage management and control system of embodiment 3 of the present disclosure. As shown in FIG. 9, a plurality of battery clusters 7131 are illustrated therein, each battery cluster 7131 includes a plurality of battery packs connected in series. Each battery cluster 7131 is connected to a corresponding high-voltage box 7133, and after passing through the high-voltage box 7133, each battery cluster 7131 is output as an independent route to the energy storage management and control system 7134, after passing through the energy storage management and control system 7134 and then output to the direct current side of the power conversion system 7135 (PCS). The power conversion system 7135 herein includes the 12 power conversion systems shown in FIG. 9. In the embodiment 3, each battery cluster 7131 corresponds to a set of high-voltage electrical modules and a power conversion system, and therefore, this solution is referred to as a "one-cluster-one-management high-voltage output solution".

By adopting the energy storage management and control system 7134 of the embodiment 3 and the one-cluster-one-management high-voltage output solution, the high-voltage output management is performed individually for each battery cluster 7131, which can avoid problems such as inter-cluster circulating current, charging and discharging barrel effect, and so on.

The present disclosure proposes an energy storage management and control system to expand the scope of application of the energy storage management and control system so that the energy storage management and control system can be compatible with the three high-voltage output solutions shown in FIGs. 7 to 9. The energy storage management and control systems of embodiment 1, embodiment 2, embodiment 3 are specifically described below in conjunction with the accompanying drawings.

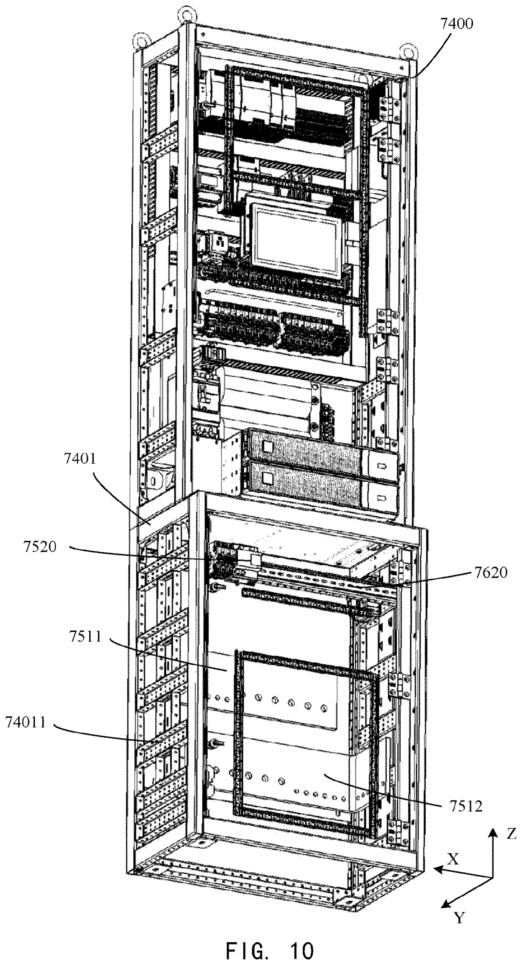

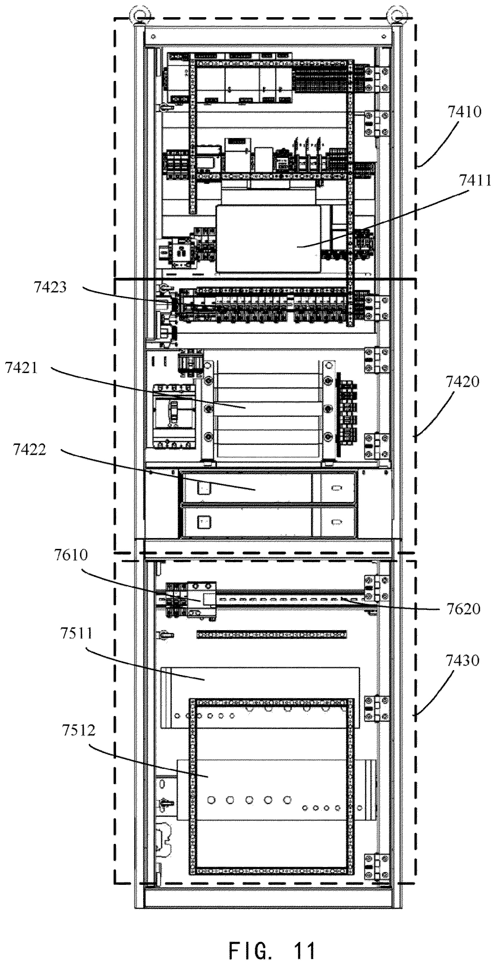

FIG. 10 is a schematic diagram of a three-dimensional structure of an energy storage management and control system of embodiment 1 of the present disclosure. The angle shown in FIG. 10 is a front-facing outward view of the energy storage management and control system 7400, wherein some panels that can cover the front of various areas are omitted. FIG. 11 is a front view of an energy storage management and control system of embodiment 1 of the present disclosure. As shown in conjunction with FIGs. 10 and 11, the energy storage management and control system 7400 includes a cabinet 7401 and a low-voltage communication and control area 7410, an alternating current power distribution area 7420, and a direct current high-voltage area 7430 provided in sequence from top to bottom. Wherein the cabinet 7401 has a roughly rectangular frame structure, and in some embodiments, the cabinet 7401 may be provided in unibody, or it may be provided as a split design as shown in FIG. 10, that is the low-voltage communication and control area 7410 and the alternating current power distribution area 7420 located above are provided in one frame structure, and the direct current high-voltage area 7430 located below is provided in another frame structure, the two frame structures are fixedly connected to each other, and the size of the two frame structures may be different. As shown in FIG. 10, the cabinet 7401 is defined to have a width along the X-axis direction, a thickness along the Y-axis direction, and a height along the Z-axis direction. The thickness and the height of the two frames can be different. The frame structure of the cabinet 7401 allows it to be flexibly connected to other components.

The low-voltage control area 7410 may also be referred to as a low-voltage communication and control area, and the power distribution area 7420 may also be referred to as an alternating current power distribution area. In some embodiments, the cabinet is provided with electrical components, and the electrical components include the direct current high-voltage electrical component, the low-voltage electrical component, the communication and control electrical component, and the alternating current power distribution component, the direct current high-voltage electrical component is provided in the direct current high-voltage area 430, the low-voltage electrical component and the communication and control electrical component both are provided in the low-voltage control area 7410, and the alternating current power distribution component is provided in the power distribution area 7420. The high-voltage electrical module hereinafter belongs to a module of the high-voltage electrical components.

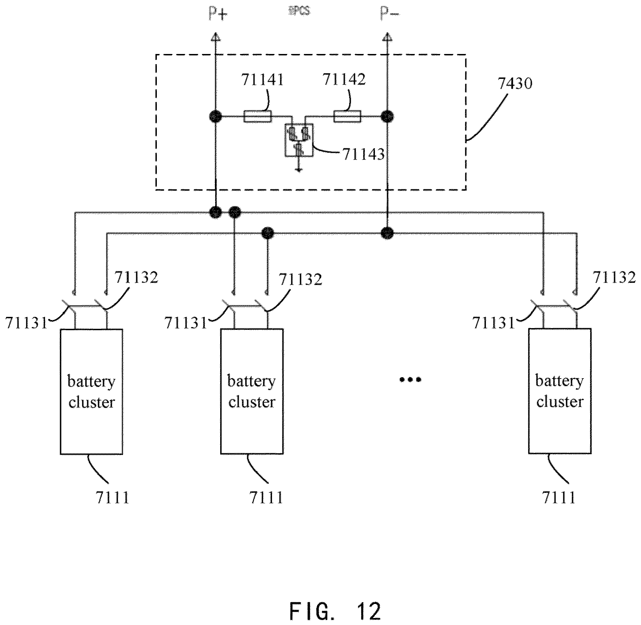

As shown in FIG. 11, a high-voltage electrical module is provided in the direct current high-voltage area 7430, the high-voltage electrical module includes one positive busbar 7511, one negative busbar 7512, and one direct current surge protection unit 7610, and in conjunction with FIG. 7, the multiple battery clusters are connected in parallel to form one output by the high-voltage electrical module, and the one output is connected to one power conversion system 7115. Specifically, the positive electrodes of the multiple battery clusters are connected to the positive busbar 7511, which are connected in parallel to form one positive bus, and then connected to the power conversion system 7115; the negative electrodes of the multiple battery clusters are all connected to the negative busbar 7512, which are connected in parallel to form one negative bus, and then connected to the power conversion system 7115. Meanwhile, the positive bus and the negative bus are also connected to ground by the direct current surge protection unit 7610, which is protected by the direct current surge protection unit 7610. FIG. 12 is used to represent a schematic diagram of a circuit in which multiple battery clusters are connected in parallel to form one route and then output to a power conversion system. Therein, when the switch 71131 is turned on, the positive electrode of each battery cluster 7111 can be connected in parallel and connected to the P+ terminal of the power conversion system (PCS), and when the switch 71132 is turned on, the negative electrode of each battery cluster 7111 can be connected in parallel and connected to the P- terminal of the power conversion system (PCS). At the same time, the positive electrodes connected in parallel are also grounded by the direct current surge protection device 71141 and the surge fuse 71143, and the negative electrodes connected in parallel are also grounded by the direct current surge protection device 71142 and the surge fuse 71143.

In the embodiment 1, the number of the high-voltage electrical module is the same as the number of the power conversion system, which is one. The cabinet 7401 is provided with a plurality of mounting members in the direct current high-voltage area 7430, the plurality of mounting members respectively corresponding to the positive busbar 7511, the negative busbar 7512, and the direct current surge protection unit 7610, and the plurality of mounting members are used to enable the high-voltage electrical module to be detachably and fixedly connected to the cabinet 7401. In some embodiments, the mounting members include an access panel, the positive busbar 7511 and the negative busbar 7512 being mountable and fixed to the access panel, and the access panel being detachably connected to an inner wall of the cabinet 7401.

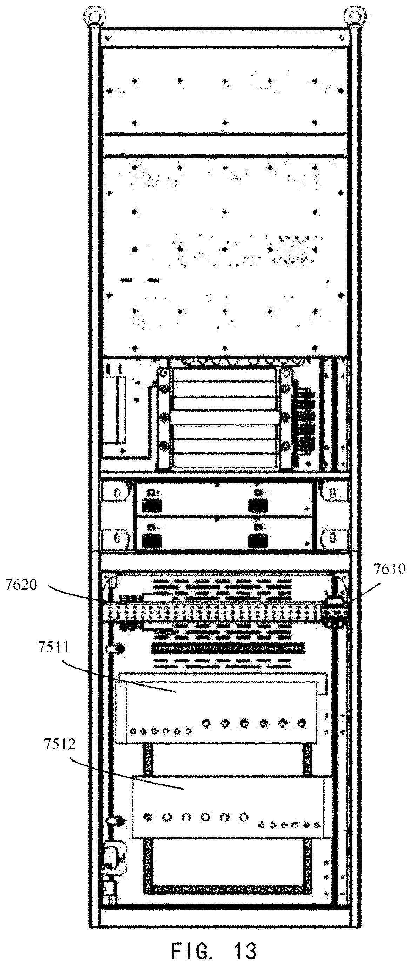

FIG. 13 is a back view of an energy storage management and control system of embodiment 1 of the present disclosure. Specifically, as shown in conjunction with FIGs. 10, 11, and 13, the positive busbar 7511 and the negative busbar 7512 are both L-shaped plate structures, wherein one side of the L-shape is used to fix them to the frame of the cabinet 7401, the corresponding mounting members for the positive busbar 7511 and the negative busbar 7512 may be fastening screws, the frame of the cabinet 7401 may be provided with some fixing plates 74011 with mounting holes, and the positive busbar 7511 and the negative busbar 7512 can be fixed to the fixing plate 74011 by means of the fastening screws and the mounting holes. The cabinet 7401 is also provided with the guide rail 7620, and the direct current surge protection unit 7610 can be provided on the guide rail 7620, the guide rail 7620 is fixed to the cabinet 7401 by means of mounting member such as fastening screw. By providing the mounting member, the high-voltage electrical module is detachably connected to the cabinet 7401. Wherein the position of the direct current surge protection unit 7610 on the guide rail 7620 can be flexibly adjusted so as to facilitate wiring. After the position is determined, the direct current surge protection unit 7610 is locked by locking member, and when the position needs to be changed, loosen the locking member and then adjust the position of the direct current surge protection unit 7610 on the guide rail 7620.

Further, with reference to FIGs. 10 and 13, a plurality of wiring holes are provided on the positive busbar 7511 with models M16 and M10, respectively, shown as several large holes (M16) and small holes (M10) in FIG. 13; and a plurality of wiring holes are provided on the negative busbar 7512 with models M16 and M10, respectively, shown as several large holes (M16) and small holes (M10) in FIG. 13. Wherein the hole M10 is connected to the direct current bus of the battery cluster 7111, and the hole M16 is connected to the direct current bus of the power conversion system 7115. This embodiment 1 corresponds to six battery clusters which are connected in parallel to form one output, so there are 6 holes M16 and M10 on the positive busbar 7511 and the negative busbar 7512, respectively. The direct current surge protection unit 7610 includes a direct current surge protection device and a surge fuse, and has an overvoltage protection module capable of realizing the overvoltage protection function. The direct current surge protection unit 7610 is provided above the positive busbar 7511 and the negative busbar 7512.

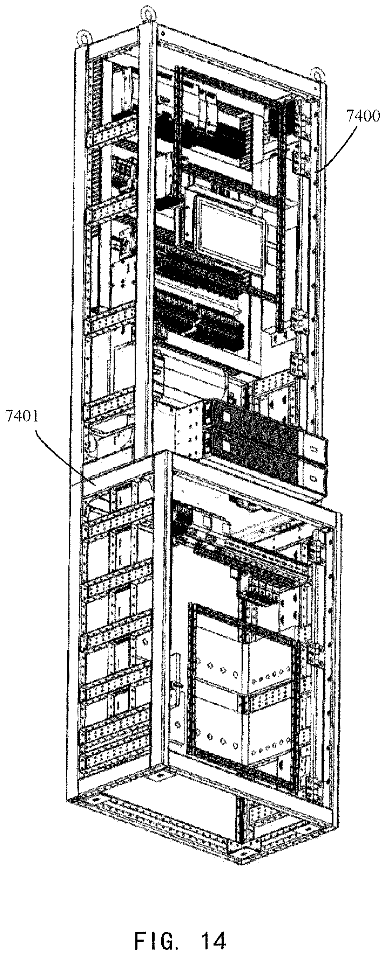

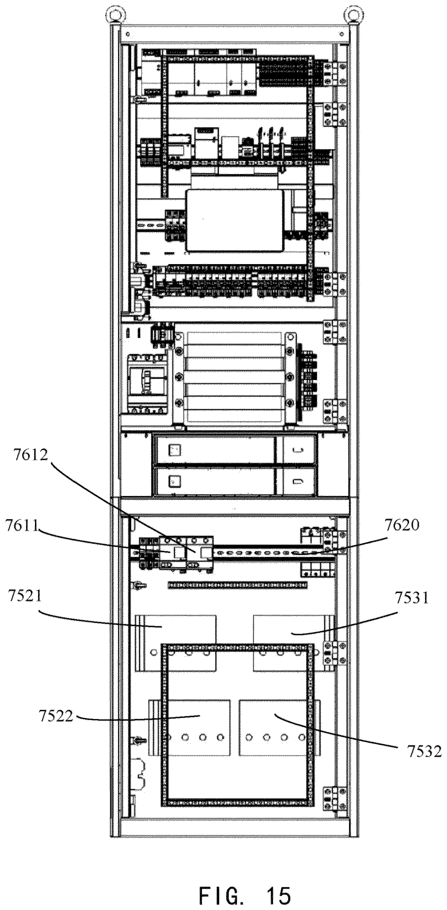

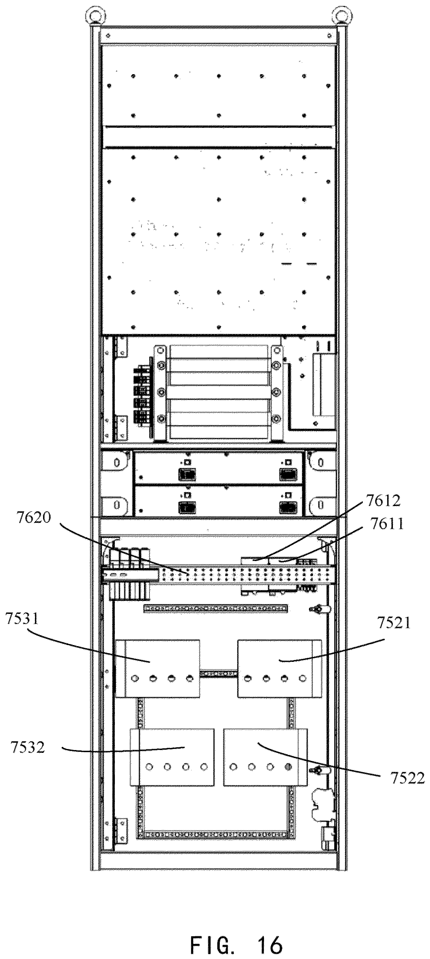

FIG. 14 is a schematic diagram of a three-dimensional structure of an energy storage management and control system of embodiment 2 of the present disclosure. Some of the structures in FIG. 14 are the same as in embodiment 1, and therefore the same labeling is used, such as energy storage management and control system 7400, cabinet 7401, and the related description can be referred to the content of the description in embodiment 1. Compared with the embodiment 1, the high-voltage electrical module in embodiment 2 is different. FIG. 15 is a front view of an energy storage management and control system of embodiment 2 of the present disclosure. FIG. 16 is a back view of an energy storage management and control system of embodiment 2 of the present disclosure. Combining FIGs. 14 to 16, the energy storage management and control system 7400 of the embodiment 2 is provided with two high-voltage electrical modules in a direct current high-voltage area of the cabinet 7401, wherein the first high-voltage electrical module includes a first positive busbar 7521, a first negative busbar 7522 and a first direct current surge protection unit 7611, the second high-voltage electrical module includes a second positive busbar 7531, a second negative busbar 7532 and a second direct current surge protection unit 7612. Combined with FIG. 8, two high-voltage electrical modules are provided in embodiment 2, and each high-voltage electrical module is used to connect multiple battery clusters in parallel to form one output, the one output is connected to a power conversion system 7125 or a power conversion system 7126. In particular, the positive electrodes and the negative electrodes of the multiple battery clusters 7121 are connected to a first positive busbar 7521 and the first negative busbar 7522, respectively, and then connected to the power conversion system 7125, and the positive electrode and the negative electrode of the plurality of battery clusters 7121 are grounded by the first direct current surge protection unit 7611, respectively; the positive electrode and the negative electrode of the plurality of battery clusters 7122 are connected to the second positive busbar 7531 and the second negative busbar 7532, respectively, and then connected to the power conversion system 7126, and the positive electrode and the negative electrode of the plurality of battery clusters 7122 are grounded by the second direct current surge protection unit 7612, respectively.

Similar to embodiment 1, the direct current surge protection units of the two high-voltage electrical modules are set on the guide rail 7620. In conjunction with the "multiple clusters connected in parallel to form two high-voltage outputs solution", the two high-voltage electrical modules can be mounted in the direct current high-voltage area using multiple mounting members.

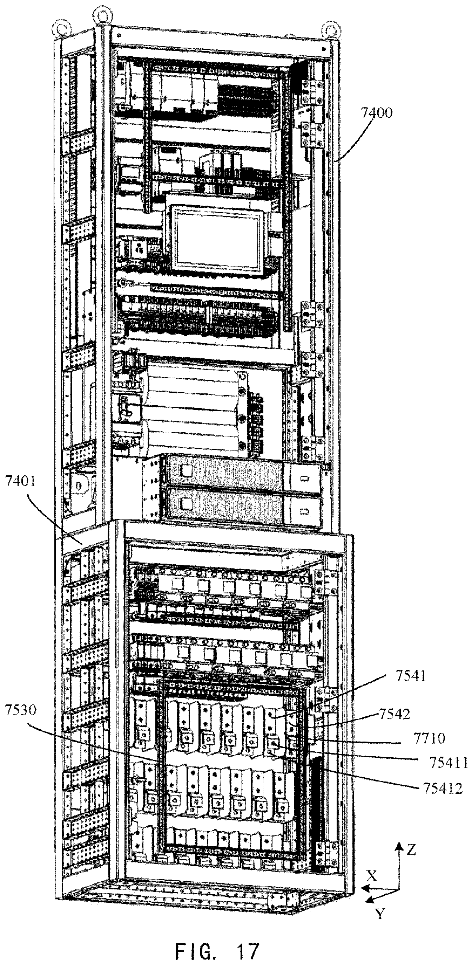

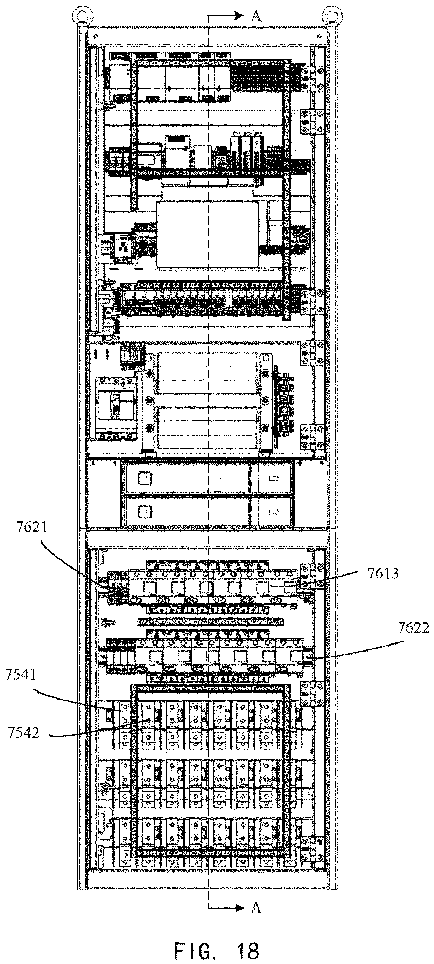

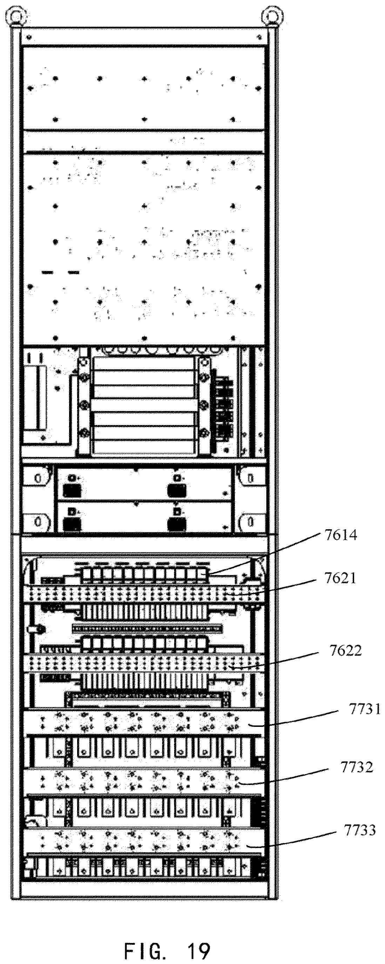

FIG. 17 is a schematic diagram of a three-dimensional structure of an energy storage management and control system of embodiment 3 of the present disclosure. Some of the structures in FIG. 17 are the same as in embodiment 1 and embodiment 2, and therefore the same labeling is used, such as the energy storage management and control system 7400, the cabinet 7401, and the related description can be referred to the contents of the description in embodiment 1 and embodiment 2. The high-voltage electrical module is different in embodiment 3 compared to the embodiment 1 and the embodiment 2. FIG. 18 is a front view of an energy storage management and control system of embodiment 3 of the present disclosure. FIG. 19 is a back view of an energy storage management and control system of embodiment 3 of the present disclosure. In conjunction with FIGs. 17 to 19, the number of the high-voltage electrical module in embodiment 3 is the same as the cluster number of the battery clusters, each high-voltage electrical module is for connecting to one battery cluster corresponding one-to-one with the high-voltage electrical module, and each high-voltage electrical module is also for connecting to one power conversion system corresponding one-to-one with the high-voltage electrical module. In conjunction with FIG. 9, there are 12 battery clusters included therein, and thus, there are 12 high-voltage electrical modules in embodiment 3, taking one of them as an example, and referring to FIG. 18, each high-voltage electrical module comprises a positive busbar 7541, a negative busbar 7542, and a direct current surge protection unit 7613, therefore, in the direct current high-voltage area, there are a total of 12 positive busbars 7541, 12 negative busbars 7542, and 12 direct current surge protection units 7613. Specifically, the positive electrode and the negative electrode of one battery cluster 7131 are connected to one positive busbar 7541 and one negative busbar 7542, respectively, and then connected to one power conversion system, the positive electrode and the negative electrode of the battery cluster 7131 are also grounded via one direct current surge protection unit 7613.

Due to space constraints, in embodiment 3, as shown in FIG. 17, the 12 positive busbars 7541 and the 12 negative busbars 7542 are provided in 3 rows extending in a horizontal direction, with 4 positive busbars 7541 and 4 negative busbars 7542 in each row, and the positive busbars 7541 and the negative busbars 7542 in the same row are arranged successively, that is one positive busbar 7541 is set alternately next to one negative busbar 7542. In the vertical direction, 3 positive busbars 7541 are provided in one column, and 3 negative busbars 7542 are provided in one column. Similar to embodiment 1 and embodiment 2, each positive busbar 7541 and negative busbar 7542 are provided with 2 connection holes for connecting the direct current bus of the corresponding battery cluster and the direct current bus of the corresponding power conversion system, respectively. Referring to FIG. 17, for each positive busbar 7541 and each negative busbar 7542, the positions of the 2 connection holes thereon within the cabinet 7401 are different, take the positive busbar 7541 in FIG. 17 as an example, one connection hole 75411 is close to the inner side, and another connection hole 75412 is close to the outer side, so as to enable the connecting wires to be clearly separated and to avoid crossing wires.

It should be noted that due to the large number of the direct current surge protection units 7613, a plurality of guide rails may be provided in the cabinet 7401 for providing the direct current surge protection units 7613. In the embodiment 3, 2 guide rails 7621, 7622 are provided in the cabinet 7401, each of them for providing 6 direct current surge protection units 7613.

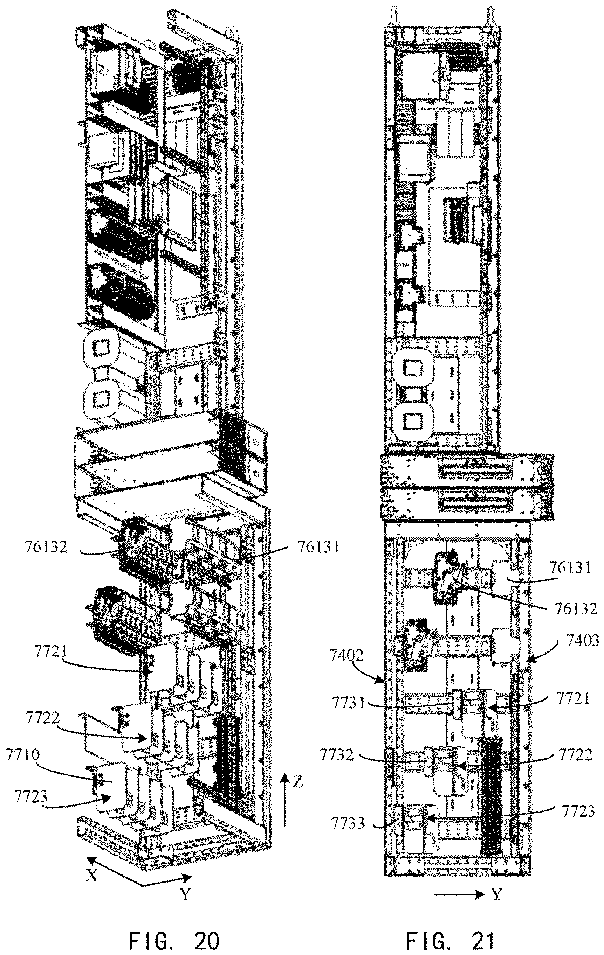

FIG. 20 is and FIG. 21 are both cross-sectional views along line AA in FIG. 18. As shown in FIGs. 20 and 21, the cabinet 7401 has a thickness in the direct current high-voltage area along the Y-axis direction, and each row of positive busbars 7541 and negative busbars 7542 is positioned differently in the direction of the thickness to avoid wiring interference. Specifically, the positive busbar 7541 and the negative busbar 7542 in embodiment 3 have three rows, the first row 7721, the second row 7722, and the third row 7723 are disposed in the height direction of the energy storage management control system, that is arranging from top to bottom along the Z-axis, and in the thickness direction, that is the position on the Y-axis is getting closer to the backside 7402 of the cabinet 7401 from top to bottom, such that the plurality of rows of positive busbars 7541 and negative busbars 7542 are stepped along the vertical direction. The advantage of such a setting is that the wiring corresponding to different rows can be clearly distinguished when wiring, avoiding the connection of wrong wires, and also conducive to preventing interference between multiple wires.

Referring to FIG. 19, 3 crossbeams 7731, 7732, 7733 are provided at the backside of the cabinet 7401 for fixing the 3 rows of positive busbars 7541 and negative busbars 7542, respectively. The crossbeams 7731, 7732, 7733 belong to mounting members for removable mounting of positive busbars 7541 and negative busbars 7542. FIG. 19 is not intended to limit the crossbeams 7731, 7732, 7733 in number and specific location, and can be set according to actual needs. Referring to FIGs. 20 and 21, the crossbeams 7731, 7732, 7733 are set in positions on the frame of the cabinet 7401 progressively closer to the backside 7402 of the cabinet 7401 in sequence. Both ends of each crossbeam 7731, 7732, 7733 can be fixed on the frame of the cabinet 7401 frame. The depth of each row of positive busbars 7541 and negative busbars 7542 inside the cabinet 7401 can be easily adjusted by setting the position of the crossbeams 7731, 7732, 7733 inside the cabinet 7401. The insulating plate 7710 may also be mounted on the crossbeams 7731, 7732, 7733.

Referring to FIGs. 17 and 20, in embodiment 3, in the same row, an insulating plate 7710 is provided between adjacent positive busbar 7541 and negative busbar 7542 for insulating adjacent positive busbar 7541 and negative busbar 7542 from each other to avoid the effect of electrical leakage or short-circuit.

Exemplarily, the insulating plate 7710 is roughly a rectangular plate that should be sized such that both the positive busbar 7541 and the negative busbar 7542 located on either side thereof are covered and shaded by the insulating plate 7710, ensuring that the electrical gap between adjacent wire clusters is maintained at least 30 mm after completion of the wiring, wherein the electrical gap refers to the distance of the shortest path in the air between two electrical components. For example, a positive wire of one battery cluster is connected to one positive busbar 7541, and the contact hole of the positive wire on the positive busbar 7541 has a contact point one, and a negative wire thereof is connected to an adjacent negative busbar 7542, and the contact hole of the negative wire on the negative busbar 7542 has a contact point two, and the shortest path in the air from the contact point one to the contact point two is start from the contact point one, passing through one surface and another surface of the insulating plate 7710 and then to the contact point two, the length of this path should be kept above 30 mm. It is clear from FIG. 20 that the projection of the insulating plate 7710 along the X-axis direction covers the positive busbar 7541 and the negative busbar 7542 behind it.

Further, the material of the insulating plate 7710 may be a resin. In a specific embodiment, the material of the insulating plate 7710 is phenolic resin and fiberglass.

Referring to FIGs. 20 and 21, in embodiment 3, the direct current surge protection unit 7613 includes a direct current surge protection device 76131 and a surge fuse 76132, wherein the surge fuse 76132 is provided behind the direct current surge protection device 76131, and the two correspond one by one. It is to be noted that the surge fuse 76132 is specifically a surge backup fuse. As shown in FIG. 21, in the two rows of direct current surge protection units 7613, the direct current surge protection devices 76131 in the first row located above and in the second row located below of the direct current surge protection units 7613 are at the same depth in the Y axis, they are close to the front side 7403 of the cabinet 7401, and the surge fuse 76132 in the first row of direct current surge protection units 7613 is closer to the front side 7403 than the surge fuse 76132 in the second row of direct current surge protection unit 7613. The advantage of such a setting is also for the convenience of wiring and to avoid wiring crosstalk. According to the foregoing, the wires of the battery clusters are connected to the direct current surge protection device 76131 after passing through the busbar, and after being connected to the surge fuse 76132 and then being grounded.

Referring to FIG. 17, in which a reinforcing rib of door panel 7530 is also shown in a rectangular shape. In some embodiments, an isolation gate (not shown) is also provided on the outside of the direct current high-voltage area, which is provided at a location corresponding to the high-voltage electrical module, and the reinforcing rib of door panel 7530 is provided on the inside of the isolation gate. In some embodiments, the isolation gate is provided with an insulating member, and the insulating member is also provided on the inner side of the isolation gate towards the interior of the cabinet 7401, so that when the isolation gate is closed, the positive busbar and the negative busbar can be shut inside, providing better isolation protection. In an embodiment, the insulating member is an insulating plate, affixed to the inside of the isolation gate, which can be sized to cover all of the positive busbar, the negative busbar, and the high-voltage electrical module. Further, when the battery cluster is connected to the high-voltage electrical module, the cables are brought together in a cable trench at the bottom of the energy storage management and control system 7400, and later connected to the power conversion system. An isolation gate is used to isolate the energy storage management and control system 7400 and the power conversion system so that the direct current high-voltage area is in a relatively closed and insulated environment to ensure safe operation of the device.

It should be noted that both the positive busbar and the negative busbar in the preceding embodiments may be copper busbars.

Referring to FIG. 11, in an embodiment of the present disclosure, the three-stage BMS, the delay relay, the switching module, the display 7411 and the like may be provided in the low-voltage communication and control area 7410, and the transformer 7421, the uninterruptible power supply system 7422, the circuit breaker 7423 and the fire module and the like may be provided in the alternating current power distribution area 7420.

According to the energy storage management and control system 7400 of the present disclosure, high-voltage electrical modules corresponding to three different solutions can be flexibly set up in the direct current high-voltage area, so that one energy storage management and control system 7400 can be compatible with three different connection solutions, they are: "multiple clusters connected in parallel to form one high-voltage output solution", "multiple clusters connected in parallel to form two high-voltage outputs solution" and "one-cluster-one-management high-voltage output solution", thereby enabling the user to configure the direct current high-voltage area according to the actual needs, and improving the utilization rate and versatility of the energy storage management and control system 7400. The solutions of embodiment 1 and embodiment 2 have the advantages of simple structure and low system cost. The one-cluster-one-management high-voltage output solution of embodiment 3 can avoid problems such as the inter-cluster circulating current and the charging and discharging barrel effect. The user can select the optimal solution based on the energy storage management and control system 7400 of the present disclosure as needed without replacing the electric control cabinet.

While some embodiments currently considered useful are discussed in the above disclosure by way of various examples, it should be understood that such details serve illustrative purposes only and are not limited to the disclosed embodiments, but rather are intended to cover all amendments and equivalent combinations that are consistent with the substance and scope of the embodiments of the present disclosure. For example, while the system components described above may be realized through hardware devices, they may also be realized through software-only solutions, such as installing the described system on an existing server or mobile device.

## Claims

1. An energy storage management and control system, wherein comprising an cabinet and electrical components provided in the cabinet;
an internal space of the cabinet is divided into a direct current high-voltage area, a low-voltage communication and control area, and an alternating current power distribution area;
the electrical components include a direct current high-voltage electrical component, a low-voltage electrical component, a communication and control electrical component, and an alternating current power distribution component, the direct current high-voltage electrical component is provided in the direct current high-voltage area, the low-voltage electrical component and the communication and control electrical component both are provided in the low-voltage communication and control area, and the alternating current power distribution component is provided in the alternating current power distribution area.

2. The energy storage management and control system according to claim 1, wherein the direct current high-voltage area is used to connect with multiple battery clusters, the direct current high-voltage area is provided with at least one high-voltage electrical module, the high-voltage electrical module comprising a positive busbar, a negative busbar, and a direct current surge protection unit, the high-voltage electrical module is used to connect with at least one battery cluster and at least one power conversion system, the number of the high-voltage electrical module is the same as the number of the power conversion system, wherein the cabinet is provided with multiple mounting members in the direct current high-voltage area, the multiple mounting members respectively corresponding to the positive busbar, the negative busbar and the direct current surge protection unit, the multiple mounting members are used to enable detachable and fixed connection of the high-voltage electrical module with the cabinet.

3. The energy storage management and control system according to claim 2, wherein the number of the high-voltage electrical module is less than a number of the battery cluster, and several battery clusters of the multiple battery clusters are connected in parallel to form one output by the high-voltage electrical module.

4. The energy storage management and control system according to claim 2, wherein the number of the high-voltage electrical module is the same as a number of the battery cluster, and each high-voltage electrical module is used to connect one battery cluster one-to-one corresponding to the high-voltage electrical module, and each high-voltage electrical module is further used to connect to one power conversion system one-to-one corresponding to the high-voltage electrical module.

5. The energy storage management and control system according to claim 4, wherein a plurality of the positive busbars and a plurality of the negative busbars are provided in multiple rows or multiple columns parallel to each other, and in the same row, the positive busbar and the negative busbar are arranged successively.

6. The energy storage management and control system according to claim 5, wherein the cabinet has a thickness in the direct current high-voltage area, with each row of the positive busbar and the negative busbar having different position in a direction of the thickness.

7. The energy storage management and control system according to claim 6, wherein a plurality of rows of the positive busbar and the negative busbar are positioned in the thickness direction closer and closer to a back of the cabinet from top to bottom.

8. The energy storage management and control system according to claim 5, wherein in the same row, an insulating plate is provided between adjacent positive busbar and negative busbar.

9. The energy storage management and control system according to claim 2, wherein the direct current high-voltage area is further provided with an isolation gate, the isolation gate is provided with an insulating member on a side close to the cabinet, and the isolation gate is provided on an outer side of the cabinet corresponding to the direct current high-voltage area.

10. The energy storage management and control system according to claim 1, wherein the direct current high-voltage electrical component comprises a high-voltage direct current load switch and a high-voltage direct current incoming and outgoing busbar, the high-voltage direct current load switch and the high-voltage direct current incoming and outgoing busbar are both fixed to an access panel, and the access panel is detachably connected to an inner wall of the cabinet;
the communication and control electrical component comprises a battery management measurement and control system, the battery management measurement and control system performs data interaction with a lower-level battery cluster control unit, an upper-level energy management system, and a power conversion system, respectively.

11. The energy storage management and control system according to claim 10, wherein the battery management measurement and control system comprises an integrated industrial control machine, a high-voltage power-on/off control unit, a fault alarm dry contact output module, a switch module and/or a serial bus module;
the high-voltage power-on/off control unit is connected to an output terminal of the integrated industrial control machine, the integrated industrial control machine sends command by the high-voltage power-on/off control unit, and the high-voltage power-on/off control unit controls the on/off of the high-voltage direct current load switch;
the integrated industrial control machine performs data interaction with the upper-level energy management system via the switch module; the integrated industrial control machine performs data interaction with the power conversion system via the switch module or the serial bus module; the integrated industrial control machine performs data interaction with the fault alarm dry contact output module via the switch module or the serial bus module, and informs the power conversion system via hardwired alarm.

12. The energy storage management and control system according to claim 11, wherein the battery management measurement and control system further comprises a temperature control unit, the temperature control unit comprises a temperature controller and a plurality of cooling fans; an acquisition terminal of the temperature controller collects the ambient temperature inside the cabinet, a data transmission terminal of the temperature controller is connected to the integrated industrial control machine via the serial bus module, and the temperature controller transmits the collected ambient temperature to the integrated industrial control machine.

13. The energy storage management and control system according to claim 12, wherein a plurality of upper heat dissipation ports are provided throughout a top wall of the cabinet, a plurality of lower heat dissipation ports are provided throughout a side wall of a lower portion of the cabinet, and the cooling fans are provided in both the upper heat dissipation port and the lower heat dissipation port.

14. The energy storage management and control system according to claim 11, wherein the battery management measurement and control system further comprises a fire unit, the fire unit comprises a smoke sensor, the smoke sensor is connected to a fire system host external to the cabinet, and the fire system host external to the cabinet is connected to the integrated industrial control machine.

15. The energy storage management and control system according to claim 10, wherein the electrical component further comprises a manual hard emergency stop unit, the manual hard emergency stop unit comprises a delay relay, the delay relay is provided in the low-voltage communication and control area and is communicatively connected to the high-voltage direct current load switch, and when manually controlling the manual hard emergency stop unit, the delay relay controls the disconnection of the high-voltage direct current load switch.

16. The energy storage management and control system according to claim 10, wherein the communication and control electrical component further comprises an uninterruptible power supply system, the uninterruptible power supply system comprises a main power supply architecture and a backup power supply architecture, the backup power supply architecture responds when the main power supply architecture is unable to work.

17. The energy storage management and control system according to claim 16, wherein the uninterruptible power supply system comprises: a first uninterruptible power supply unit, a second uninterruptible power supply unit, a redundant module, and a host computer module; wherein
both the first uninterruptible power supply unit and the second uninterruptible power supply unit comprise a switching power supply module, a UPS module, and a lead-acid battery module, respectively, wherein an alternating current input terminal of the switching power supply module is connected to a power grid system, an output terminal of the switching power supply module is connected to an input terminal of the UPS module, an output terminal of the UPS module is connected to an input terminal of the lead-acid battery module, the lead-acid battery module is connected to the redundant module via the UPS module; an output terminal of the redundant module is connected to a load of an energy storage system;
an input terminal of the host computer module is connected to the output terminal of the switching power supply module, the output terminal of the UPS module and the output terminal of the redundant module.

18. The energy storage management and control system according to claim 17, wherein the switching power supply module comprises a rectifier module and a filter module, wherein an output terminal of the rectifier module is connected to an input terminal of the filter module; and an output terminal of the filter module is connected to the input terminal of the UPS module.

19. The energy storage management and control system according to claim 17 or 18, wherein the UPS module comprises a decoupling module, a charging module, a first switching element and a dry contact module, wherein
an input terminal of the decoupling module is connected to the output terminal of the switching power supply module;
an output terminal of the decoupling module is connected to an input terminal of the charging module, the first switching element, an input terminal of the dry contact module, and an input terminal of the redundant module;
the input terminal of the lead acid battery module is connected to an output terminal of the charging module, the first switching element, and an output terminal of the dry contact module.
